# DEMANDE DE BREVET EUROPEEN

(11) **EP 4 365 007 A1**
(43) Date de publication de la demande: **08.05.2024**
(21) Numéro de dépôt: 23206671.2
(22) Date de dépôt: 30.10.2023
(51) Int. Cl.: B60L 3/00, B60L 7/00

(54) **INTERRUPTEUR DE DÉBRAYAGE DE FREINAGE D'UNE ROUE MOTRICE ENTRAÎNÉE PAR UN MOTEUR ÉLECTRIQUE**

(30) Priorité: 04.11.2022 FR 2211514
(71) Demandeur: Aldebaran, 75015 Paris (FR)
(72) Inventeur: MONACI, Alexis, 75015 PARIS (FR)
(74) Mandataire: Atout PI Laplace

(57) **Abrégé**

L'invention concerne un interrupteur de débrayage de freinage (20) d'une roue motrice entraînée par un moteur électrique biphasé, l'interrupteur (20) comprenant une première voie de débrayage (22) connectée selon une première extrémité (220) à une phase du moteur et à une deuxième phase du moteur selon une deuxième extrémité (221), la première voie (22) basculant entre un état ouvert et fermé, l'interrupteur (20) comprenant un dispositif de surveillance (24) de la première voie (22), le dispositif de surveillance (24) comprenant :
- un premier émetteur (240) connecté à la première extrémité (220) de la première voie de débrayage (22), configuré pour injecter un premier signal d'état (s1) entre la première extrémité (220) de la première voie de débrayage (22) et la phase moteur du moteur électrique (10)),
- un premier récepteur (242) connecté la deuxième extrémité (221) de la première voie de débrayage (22), configuré pour détecter le premier signal (s1) traversant la première voie (22) lorsque la première voie (22) est à l'état fermée, le premier récepteur (242) étant configuré pour déterminer l'état de la première voie (22).

## Description

L'invention concerne une roue motrice destinée à mouvoir un véhicule et à un dispositif de freinage électrique de cette roue motrice.

De façon classique les véhicules à roues multiples sont équipés de roues motrices leur permettant notamment d'être entraîné dans une direction souhaitée. Les roues sont généralement entraînées en rotation pas le biais d'un moteur électrique directement relié à chaque roue.

Il est connu d'utiliser aujourd'hui, un ensemble motorisé nommé moteur roue. Le moteur-roue est un ensemble qui comprend un moteur incorporé directement dans la roue motrice, lequel est capable de propulser le véhicule. Les principaux avantages d'un tel système moteur roue sont son encombrement réduit et le fait qu'il ne nécessite pas de transmission entre le moteur et la roue.

Pendant la phase de mobilité du véhicule, il est nécessaire, pour des raisons de sécurité évidentes, de pouvoir permettre au véhicule entraîné de freiner et de s'arrêter à la détection d'un obstacle ou d'un danger. Plusieurs solutions existent comme l'installation d'un moyen de freinage mécanique, comme un patin ou un disque, sur la roue directement afin de ralentir la rotation de cette dernière ou encore l'installation d'un moyen de freinage de type magnétique sur le moteur directement de sorte à dissiper une partie de l'énergie de freinage.

Ces moyens de freinage sont effectivement essentiels pendant les phases d'autonomie et de mobilité du véhicule mais présentent de forts inconvénients lorsque le véhicule est piloté pendant une phase où ce dernier n'est plus autonome. Il s'agit par exemple de phases de déplacement du véhicule par un utilisateur le poussant ou le tractant entre différents lieux ou encore lors de situation de disfonctionnement ou d'absence de fonctionnement du véhicule nécessitant d'être suppléé pour se déplacer.

En effet, le moteur électrique étant directement connecté à la roue motrice, il n'est pas possible de vouloir déplacer la roue motrice, en poussant ou en tractant le véhicule par exemple, sans observer une résistance de la part du moteur électrique ou un endommagement de ce dernier.

Il devient alors nécessaire d'ajouter un organe de débrayage entre le moteur électrique et la roue motrice entraînée par le moteur électrique. Cependant, cet ajout augmente considérablement l'encombrement de l'ensemble roue moteur, ce qui présente un inconvénient à cet ajout.

L'invention vise à pallier tout ou partie des problèmes cités plus haut en proposant un dispositif de débrayage du freinage de la roue motrice aisément incorporable dans le système roue moteur, pouvant fonctionner lorsque le véhicule est éteint ou allumé et présentant un faible encombrement.

A cet effet, l'invention a pour objet un interrupteur de débrayage de freinage d'une roue motrice entraînée en rotation par un moteur électrique comprenant au moins deux phases moteur, l'interrupteur de débrayage de freinage comprenant une première voie de débrayage destinée à être connectée selon une première extrémité de la première voie de débrayage à une phase moteur du moteur électrique et à une deuxième phase moteur du moteur électrique selon une deuxième extrémité de la première voie de débrayage, la première voie de débrayage étant configurée pour basculer entre un état ouvert et un état fermé, l'interrupteur de débrayage de freinage comprenant un dispositif de surveillance de l'état de la première voie de débrayage, le dispositif de surveillance comprenant :
- un premier émetteur d'état connecté à la première extrémité de la première voie de débrayage, configuré pour injecter un premier signal d'état entre la première extrémité de la première voie de débrayage et la phase moteur du moteur électrique,
- un premier récepteur d'état connecté la deuxième extrémité de la première voie de débrayage, le premier récepteur d'état étant configuré pour détecter le premier signal d'état traversant la première voie de débrayage lorsque la première voie de débrayage est à l'état fermée, le premier récepteur d'état étant configuré pour déterminer l'état de la première voie de débrayage.

Selon un aspect de l'invention, le premier émetteur d'état comprend :
- une première commande configurée pour générer le premier signal d'état,
- un premier transistor connecté à la première commande selon une première borne, connecté à une alimentation selon une deuxième borne et comprenant une troisième borne,
- un deuxième transistor connecté à la première commande par l'intermédiaire d'une première borne, connecté à une masse par l'intermédiaire d'une troisième borne et connecté à la troisième borne du premier transistor par l'intermédiaire d'une deuxième borne,
- un premier moyen de filtrage connecté selon une première borne du premier moyen de filtrage à la troisième borne du premier transistor et à la deuxième borne du deuxième transistor et selon une deuxième borne du premier moyen de filtrage à la première extrémité de la première voie de débrayage.

Selon un aspect de l'invention, le premier signal d'état est un signal périodique de fréquence supérieur ou égale à 100kHz.

Selon un aspect de l'invention, l'interrupteur de débrayage de freinage comprend un premier filtre positionné entre la phase moteur du moteur électrique et la première extrémité de la première voie de débrayage, le premier filtre étant configuré pour recevoir et filtrer un signal de la phase moteur du moteur électrique.

Selon un aspect de l'invention, le premier filtre est un filtre passe-bas.

Selon un aspect de l'invention, le premier filtre est un filtre de type en T, comprenant deux inductances et un condensateur.

Selon un aspect de l'invention, l'interrupteur de débrayage de freinage comprend un troisième filtre connecté à la deuxième extrémité de la première voie de débrayage, configuré pour filtrer le premier signal d'état émis par le premier émetteur d'état.

Selon un aspect de l'invention, l'interrupteur de débrayage de freinage comprend une deuxième voie de débrayage connectée à la phase moteur du moteur électrique selon une première extrémité de la deuxième voie de débrayage et à la deuxième phase moteur du moteur électrique selon une deuxième extrémité de la deuxième voie de débrayage, la deuxième voie de débrayage étant configurée pour basculer entre un état ouvert et un état fermé, la deuxième voie de débrayage étant configurée pour être dans le même état que la première voie de débrayage, le dispositif de surveillance étant configuré pour surveiller l'état de la deuxième voie de débrayage, le dispositif de surveillance comprenant :
- un deuxième émetteur d'état connecté à la première extrémité de la deuxième voie de débrayage, configuré pour injecter un deuxième signal d'état entre la première extrémité de la deuxième voie de débrayage et la phase moteur du moteur électrique,
- un deuxième récepteur d'état connecté à la deuxième extrémité de la deuxième voie de débrayage, le deuxième récepteur d'état étant configuré pour détecter le deuxième signal d'état traversant la deuxième voie de débrayage lorsque la deuxième voie de débrayage est à l'état fermée, le deuxième récepteur d'état étant configuré pour déterminer l'état de la deuxième voie de débrayage,
- un dispositif de diagnostic de l'état de l'interrupteur de débrayage, le dispositif de diagnostic étant relié au premier récepteur d'état et au deuxième récepteur d'état, le dispositif de diagnostic étant configuré pour comparer l'état de la première voie de débrayage et l'état de la deuxième voie de débrayage, le dispositif de diagnostic étant configuré pour déterminer, à partir de la comparaison, si l'interrupteur de débrayage est dans un état fonctionnel ou dans un état dysfonctionnel.

Selon un aspect de l'invention, le deuxième émetteur d'état comprend :
- une deuxième commande configurée pour générer le deuxième signal d'état,
- un troisième transistor comprenant une première borne de troisième transistor connectée à la deuxième commande, comprenant une deuxième borne de troisième transistor connectée une l'alimentation et une troisième borne,
- un quatrième transistor comprenant une première borne de quatrième transistor connectée à la deuxième commande, comprenant une troisième borne de quatrième transistor connectée à une masse et une deuxième borne de quatrième transistor connectée à la troisième borne du troisième transistor,
- un deuxième moyen de filtrage connecté selon une première borne du deuxième moyen de filtrage à la deuxième borne du quatrième transistor et à la troisième borne du troisième transistor et selon une deuxième borne du deuxième moyen de filtrage à la première extrémité de la deuxième voie de débrayage.

Selon un aspect de l'invention, le deuxième signal d'état est un signal périodique de fréquence supérieur ou égale à 100kHz.

Selon un aspect de l'invention, l'interrupteur de débrayage de freinage comprend un deuxième filtre positionné entre la phase moteur du moteur électrique et la première extrémité de la deuxième voie de débrayage configuré pour recevoir et filtrer un signal de la phase moteur du moteur électrique.

Selon un aspect de l'invention, le deuxième filtre est un filtre passe-bas.

Selon un aspect de l'invention, le deuxième filtre est un filtre de type en T, comprenant deux inductances et un condensateur.

Selon un aspect de l'invention, l'interrupteur de débrayage de freinage comprend un quatrième filtre connecté à la deuxième extrémité de la deuxième voie de débrayage, configuré pour filtrer le deuxième signal d'état émis par le deuxième émetteur d'état.

Selon un aspect de l'invention, le moteur électrique comprend trois phases moteur, la phase moteur étant une phase moteur parmi la première phase moteur ou la troisième phase moteur.

L'invention a également trait à un véhicule configuré pour se mouvoir dans une zone de déplacement, le véhicule comprenant l'interrupteur de débrayage de freinage.

L'invention sera mieux comprise et d'autres avantages apparaîtront à la lecture de la description détaillée d'un mode de réalisation donné à titre d'exemple, description illustrée par le dessin joint dans lequel :
[Fig.1] la figure 1 représente une vue schématique d'un dispositif de freinage de roue motrice dans une configuration de freinage comprenant un interrupteur de débrayage de freinage de roue motrice selon l'invention ;
[Fig.2] la figure 2 représente une vue schématique du dispositif de freinage de roue motrice de la figure 1 dans une seconde configuration architecturale ;
[Fig.3] la figure 3 représente une vue schématique d'un dispositif de freinage de roue motrice dans une configuration de freinage comprenant un interrupteur de débrayage de freinage de roue motrice selon une variante avec un moteur électrique en deux phases ;
[Fig.4] la figure 4 représente une vue schématique de l'interrupteur de débrayage de freinage de roue motrice selon l'invention ;
[Fig.5] la figure 5 représente une vue schématique de l'interrupteur de débrayage de freinage de la figure 4 dans une configuration redondante ;
[Fig.6] la figure 6 représente une vue schématique de l'interrupteur de débrayage de freinage de la figure 5 comprenant un système de filtrage ;
[Fig.7] la figure 7 représente une vue schématique d'une architecture d'un premier émetteur de l'interrupteur de débrayage de freinage de la figure 6 ;
[Fig.8] la figure 8 représente une vue schématique d'une architecture d'un deuxième émetteur de l'interrupteur de débrayage de freinage de la figure 6 ;
[Fig.9] la figure 9 représente une vue schématique d'une configuration complète de l'interrupteur de débrayage de freinage de deux roues motrices selon l'invention.

Par souci de clarté, les mêmes éléments porteront les mêmes repères dans les différentes figures.

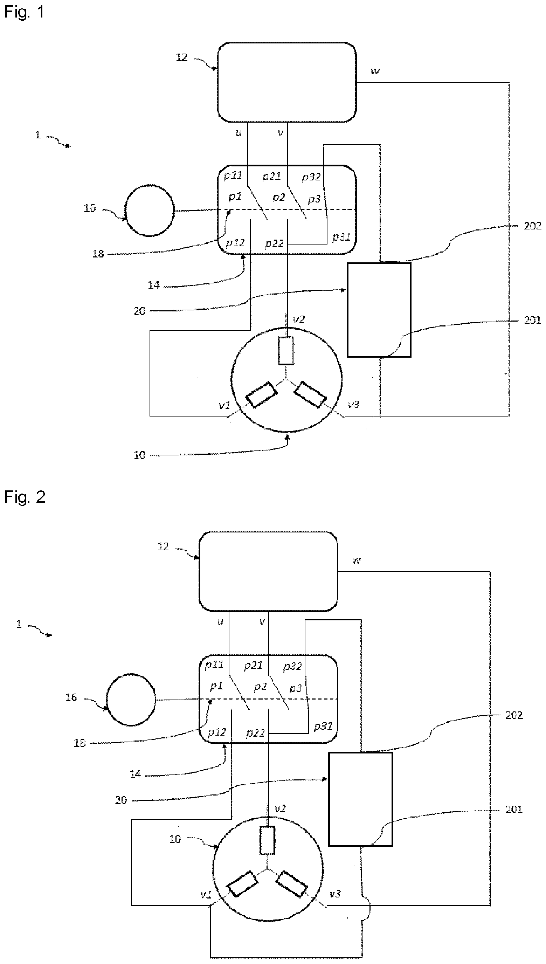

La figure 1 représente une vue schématique d'un dispositif de freinage 1 de roue motrice montée sur un véhicule. Ce type de véhicule mouvant peut comprendre une pluralité de roues motrices entraînées par un moteur électrique.

Le dispositif de freinage 1 comprend donc un moteur électrique 10 triphasé, de puissance nominale inférieure à un kilowatt, configuré pour entraîner en rotation la roue motrice. Le moteur électrique 10 est alimenté par une commande 12 qui délivre 3 tensions *(u, v, w)*, chaque tension de commande *(u,v,w)* étant respectivement reliée à une phase moteur *(v1, v2, v3)* du moteur électrique 10 triphasé. Le moteur électrique 10 est un moteur triphasé en branchement étoile permettant ainsi au moteur électrique 10 d'être soumis à une tension réduite. A titre d'exemple indicatif, la commande 12 se compose d'un hacheur ou d'un onduleur découpant une tension en modulation de largeur d'impulsions de fréquence supérieure à 10kHz.

En variante, le moteur électrique 10 est un moteur triphasé en branchement triangle.

Le dispositif de freinage 1 comprend également un relais électromécanique de sécurité 14 à trois voies *(p1, p2, p3).* Le relais électromécanique de sécurité 14 comprend une première voie *p1* connectée à une première tension de commande *u* de la commande 12 selon une première extrémité *p11* de la première voie *p1* et à une première phase moteur *v1* du moteur électrique 10 selon une seconde extrémité *p12* de la première voie *p1.* Le relais électromécanique de sécurité 14 comprend une deuxième voie *p2* connectée à une deuxième tension de commande *v* de la commande 12 selon une première extrémité *p21* de la deuxième voie *p2 et* à une deuxième phase moteur *v2* du moteur électrique 10 selon une seconde extrémité *p22 de* la deuxième voie *p2.* Le relais électromécanique de sécurité 14 comprend une troisième voie *p3* connectée à la deuxième phase moteur *v2* du moteur électrique 10 selon une première extrémité *p31* de la troisième voie *p3* et à une troisième phase moteur *v3* du moteur électrique 10 selon une seconde extrémité *p32* de la troisième voie *p3*.

Selon une variante représentée en figure 2, il peut être envisagé que la troisième voie *p3* soit connectée à la deuxième phase moteur *v2* du moteur électrique 10 selon la première extrémité *p31* de la troisième voie *p3* et à la première phase moteur *v1* du moteur électrique 10 selon la seconde extrémité *p32* de la troisième voie *p3*.

La première voie *p1,* la deuxième voie *p2* et la troisième voie *p3* sont configurées pour basculer entre un état ouvert et un état fermé. En effet, la première voie *p1,* la deuxième voie *p2* et la troisième voie *p3* fonctionne comme des interrupteurs entre la commande 12 et le moteur électrique 10. Dès lors, lorsque la première voie *p1* est dans un état fermé ou passant par rapport au courant, la première tension de commande *u* est connectée à la première phase moteur *v1* de sorte que la première phase moteur *v1* est alimentée en courant. A l'inverse, lorsque la première voie *p1* est dans un état ouvert ou bloquant par rapport au courant, la première phase moteur *v1* n'est alors plus alimentée en courant par la première tension de commande *u* de la commande 12.

Et, de manière similaire, lorsque la deuxième voie *p2* est dans un état fermé ou passant par rapport au courant, la deuxième tension de commande *v* est connectée à la deuxième phase moteur *v2* de sorte que la deuxième phase moteur *v2* est alimentée en courant. A l'inverse, lorsque la deuxième voie *p2* est dans un état ouvert ou bloquant par rapport au courant, la deuxième phase moteur *v2* n'est alors plus alimentée en courant par la deuxième tension de commande *v* de la commande 12.

Et, enfin, lorsque la troisième voie *p3* est dans un état fermé ou passant par rapport au courant, la troisième phase moteur *v3* dans la configuration représentée en figure 1, ou la première phase moteur *v1* dans la configuration représentée en figure 2, est connectée à la deuxième phase moteur *v2* de sorte à interconnecter deux phases moteurs *v2* et *v3* du moteur électrique 10 et à générer un courant de court-circuit entre ces deux phases moteurs, à savoir *v2* et *v3* dans la configuration de la figure 1, ou *v2* et *v1* dans la configuration de la figure 2. A l'inverse, lorsque la troisième voie *p3* est dans un état ouvert ou bloquant, la troisième phase moteur *v3* dans la configuration de la figure 1, ou la première phase moteur *v1* dans la configuration de la figure 2, n'est alors plus branchée à la deuxième phase moteur *v2* du moteur électrique 10, la troisième phase moteur *v3* étant toujours connectée à la troisième tension de commande *w* de la commande 12.

Le relais électromécanique de sécurité 14 comprend également un organe de commande commune 16 de la première, deuxième et troisième voie *(p1, p2, p3)* configuré pour commander simultanément la première voie, la deuxième voie et la troisième voie *(p1, p2, p3).* L'organe de commande commune 16 est, à titre d'exemple indicatif, un actionneur mécanique permettant de générer une bascule presque simultanée de la première voie *p1,* de la deuxième voie *p2* et de la troisième voie *p3* d'un état à un autre parmi l'état ouvert ou l'état fermé. Autrement dit, lorsque la première, la deuxième ou la troisième voie *(p1, p2, p3)* subit une bascule d'état entre l'état ouvert et l'état fermé, alors les autres voies subissent également une bascule entre l'état ouvert et l'état fermé.

En variante, l'organe de commande commune 16 peut également être un actionneur électrique permettant de commander simultanément la première voie, la deuxième voie et la troisième voie *(p1, p2, p3).*

Le relais électromécanique de sécurité 14 comprend également un organe de sécurité 18 configuré pour générer une interdépendance entre la première voie *p1,* la deuxième voie *p2* et la troisième voie *p3.*

En outre, la première voie *p1* et la deuxième voie *p2* est dans un état opposé à la troisième voie *p3.* Autrement dit, lorsque la première voie *p1* est dans un état fermé, alors la deuxième voie *p2* est également dans un état fermé et la troisième voie *p3* est dans un état ouvert. Dès lors, si la première voie *p1* est dans l'état fermé alors :
- la première phase moteur *v1* et la deuxième phase moteur *v2* sont alimentées par le biais de la première et de la deuxième voie *p1* et *p2* du relais électromécanique de sécurité 14 en sachant que la troisième phase moteur *v3* est continuellement alimentée par la troisième tension de commande *w*,
- et la deuxième phase moteur *v2* et la troisième phase moteur *v3* ne sont pas reliées entre elles évitant ainsi de générer un court-circuit entre ces deux phases moteur dans la configuration de la figure 1. Dans la configuration de la figure 2, c'est alors la deuxième phase moteur *v2* et la première phase moteur *v1* qui ne sont pas reliées entre elles évitant ainsi de générer un court-circuit entre ces deux phases moteur.

Il en va de même si c'est la deuxième voie *p2* qui est dans l'état fermé ou si c'est la troisième voie *p3* qui est dans l'état ouvert.

Et, si la première voie *p1* est dans l'état ouvert alors :
- La première phase moteur *v1* n'est pas alimentée par la commande 12,
- La deuxième phase moteur *v2* n'est également pas alimentée par la commande 12 en sachant que la troisième phase moteur *v3* est continuellement alimentée par la troisième tension de commande *w*,
- Et la deuxième phase moteur *v2* et la troisième phase moteur *v3* sont connectées entre elles, dans la configuration de la figure 1, générant ainsi un court-circuit entre ces deux phases moteur, le courant de court-circuit généré entre la deuxième phase moteur *v2* et la troisième phase moteur *v3* pouvant être alors interprété comme un courant de freinage du moteur électrique 10. Ce courant de freinage génère alors un freinage magnétique du moteur électrique 10. Dans la configuration de la figure 2, il s'agit alors de la deuxième phase moteur *v2* et de la première phase moteur *v1.*

Ainsi, l'organe de commande commune 16 permet d'actionner toutes les voies du relais électromécanique de sécurité 14 par le biais d'une seule action et l'organe de sécurité 18 permet générer cette interdépendance entre les première, deuxième et troisième voies *(p1, p2, p3)* et d'empêcher toute bascule d'état en cas de disfonctionnement d'une des première, deuxième ou troisième voies *(p1, p2, p3).* En effet, si la première voie *p1* ou la deuxième voie *p2* est, par exemple, bloqué dans l'état fermé, ou collé, alors l'organe de sécurité 18 empêche toute bascule de l'autre voie parmi la première voie *p1* et la deuxième voie *p2* qui n'est pas bloqué dans l'état fermé et de la troisième voie *p3* de l'état ouvert à l'état fermé permettant ainsi de ne pas dégrader le relais électromécanique de sécurité 14 ou la commande 12.

Selon un deuxième exemple indicatif, si la troisième voie *p3* bloqué dans l'état ouvert, alors l'organe de sécurité 18 empêche toute bascule de la première voie *p1* et de la deuxième voie *p2* qui ne sont pas bloquées dans l'état fermé.

Ainsi, le relais électromécanique de sécurité 14 est configuré pour permettre, selon une première configuration du relais électromécanique de sécurité, au moteur électrique 10 d'être alimenté en tension par la commande 12 en induisant la connexion entre la première tension de commande *u* et la première phase moteur *v1* ainsi que la connexion électrique entre la deuxième tension de commande *v* et la deuxième phase moteur *v2,* la troisième phase moteur *v3* étant continuellement alimentée par la troisième tension de commande *w* et permettre, selon une deuxième configuration ou configuration de freinage, de simultanément interrompre la connexion électrique entre la commande 12, et particulièrement la première tension de commande *u* et la deuxième tension de commande *v*, et les première et deuxième phases moteur *v1* et *v2* du moteur électrique 10 et générer un courant de freinage entre la deuxième phase moteur *v2* du moteur électrique 10 et le troisième phase moteur *v3* du moteur électrique 10.

En outre, le terme simultané se comprend comme une bascule de la première voie *p1,* de la deuxième voie *p2* et de la troisième voie *p3* d'un état à un autre état dans un temps faible voire instantané lorsque l'une des voies *(p1, p2, p3)* effectue une bascule d'état entre l'état fermé et l'état ouvert par le biais de l'actionnement de l'organe de commande commune 16. On entend par « temps faible », un temps de bascule inférieur à 200ms. De plus, de manière préférentielle, la bascule simultanée de toutes les voies *(p1, p2, p3)* du relais électromécanique de sécurité 14, débute par la bascule de la première voie *p1* et de la deuxième voie *p2* puis la bascule de la troisième voie *p3* de sorte à éviter d'alimenter le moteur électrique selon les trois phases moteurs *(v1, v2, v3)* tout en générant le court-circuit entre la deuxième phase moteur *v2* et la troisième phase moteur *v3* dans la configuration de la figure 1, ou entre la deuxième phase moteur *v2* et la première phase moteur *v1* selon la configuration de la figure 2, ce qui dégrade fortement le relais électromécanique de sécurité 14 ou la commande 12.

En variante, la bascule simultanée de toutes les voies *(p1, p2, p3)* du relais électromécanique de sécurité 14, débute par la bascule de la troisième voie *p3* puis par la bascule de la première voie *p1* et de la deuxième voie *p2,* la bascule de la première voie *p1* et de la deuxième voie *p2* se faisant dans un temps limité à la suite de la bascule de la troisième voie *p3* de sorte à éviter de trop fortement impacter le relais électromécanique de sécurité 14 ou la commande 12.

Ainsi, pendant la configuration de freinage, le moteur électrique 10 n'est alimenté en courant par la commande 12 que par le biais de la troisième phase moteur *v3* qui est continuellement connectée avec la tension de commande *w.* Les première et deuxième phases moteur *v1* et *v2* sont isolées de la commande 12 du fait de l'état ouvert de la première voie *p1* et de l'état ouvert de la deuxième voie *p2* du relais électromécanique de sécurité 14. De plus, l'ouverture de la première voie *p1* et de la deuxième voie *p2* induit, selon la configuration architecturale du relais électromécanique de sécurité 14, un état de fermeture de la troisième voie *p3*. La troisième voie *p3* relie alors la deuxième phase moteur *v2* et la troisième phase moteur *v3* selon la configuration de la figure 1, ou la deuxième phase moteur *v2* et la première phase moteur *v1* dans la configuration de la figure 2, de sorte à générer un courant de freinage entre ces deux phases moteur. Dès lors, une même tension est observable respectivement entre la deuxième phase moteur *v2* et la troisième phase moteur *v3* dans la configuration de la figure 1, ou entre la deuxième phase moteur *v2* et la première phase moteur *v1* dans la configuration de la figure 2 et il est possible d'observer sur une rotation en trois phase moteur *(v1, v2, v3)* un blocage au niveau de la deuxième phase moteur *v2* et de la troisième phase moteur *v3* alors que la première phase moteur *v1* est laissée libre, c'est-à-dire qu'il n'y a pas de retour de courant possible par une autre phase moteur, à savoir la deuxième phase moteur *v2* ou la troisième phase moteur *v3* et qu'il n'y a pas de courant injecté possible par la commande 12 puisqu'il n'y a qu'un seule phase moteur, à savoir la troisième phase moteur *v3* branchée, dans le cas de configuration de la figure 1. Dans la configuration de la figure 2, c'est alors un blocage au niveau de la deuxième phase moteur *v2* et de la première phase moteur *v1* qui est observable.

Ce couple de freinage ou freinage magnétique induit par le courant de freinage entre la deuxième phase moteur *v2* et la troisième phase moteur *v3* dans la configuration de la figure 1, ou entre la deuxième phase moteur *v2* et la première phase moteur *v1* dans la configuration de la figure 2, présente l'avantage, comparé à un court-circuit des trois phases moteur, de réduire le couple de freinage et donc de réduire grandement un potentiel dérapage de la roue motrice et du véhicule motorisé améliorant l'aspect de sécurité de la roue motrice. En outre, le fait de court-circuiter seulement deux phases moteurs (*v2, v3* ou *v2, v1)* présente également l'avantage, en limitant un potentiel dérapage, de permettre d'avoir une mesure fiable de la distance parcourue en se basant sur la rotation de la roue motrice et de préciser les mesures d'odométrie liées à la roue motrice.

Ainsi, la roue motrice peut être dans deux configurations binaires, soit un entraînement de la roue motrice par le moteur électrique 10 selon les caractéristiques techniques du moteur électrique, par exemple la vitesse de rotation du rotor du moteur électrique 10, soit un freinage de la roue motrice par le biais de la configuration de freinage du relais électromécanique de sécurité 14 induisant un couple de freinage du moteur électrique. En outre, lorsque le véhicule qui se déplace par le biais de la roue motrice est éteint, c'est la configuration de freinage qui est présente par défaut. Tel quel, il n'est alors pas possible d'envisager de déconnecter complètement la roue motrice du moteur électrique 10 de sorte à libérer la roue motrice de toute influence du moteur électrique 10.

Afin de permettre de déconnecter la roue motrice du moteur électrique 10 notamment lorsque le couple de freinage est détectable et appliqué entre la deuxième phase moteur *v2* et la troisième phase moteur *v3* dans la configuration de la figure 1, un interrupteur de débrayage de freinage 20 est connecté à la seconde extrémité *p32* de la troisième voie *p3* par l'intermédiaire d'une seconde borne 202 de l'interrupteur d'embrayage 20 et à la troisième phase moteur *v3* du moteur électrique 10 selon une première borne 201 du premier interrupteur de débrayage 20. Dans la configuration de la figure 2, la première borne 201 du premier interrupteur de débrayage 20 est connectée à la première phase moteur *v1* du moteur électrique 10.

L'interrupteur de débrayage de freinage 20 peut être par exemple un élément mécanique capable de débrayer même lorsqu'il n'y a pas d'alimentation.

En variante, l'interrupteur de débrayage de freinage 20 peut être un élément électrique comme un transistor ou un élément électromécanique comme un relais électromécanique, apte à fonctionner lorsque le véhicule allumé ou si le freinage n'est pas présent par défaut lorsque le véhicule est éteint.

De manière similaire aux voies (*p1, p2, p3)* du relais électromécanique de sécurité 14, l'interrupteur de débrayage 20 est configuré pour basculer entre un état ouvert ne laissant pas passer le courant et un état fermé laissant passer le courant.

L'interrupteur de débrayage 20 permet ainsi d'empêcher la connexion entre la deuxième phase moteur *v2* et la troisième phase moteur *v3* dans la configuration de la figure 1 notamment lorsque la troisième voie *p3* est dans l'état fermé et qu'un courant de de court-circuit, ou courant de freinage, est détecté et appliqué entre la deuxième phase moteur *v2* et la troisième phase moteur *v3.* Ainsi, la deuxième phase moteur *v2* est débrayée de la troisième phase moteur *v3* et le freinage sur le moteur électrique 10 ne s'applique plus. Le moteur électrique 10 et donc la roue motrice sont alors laissés libres puisque le pilotage de la seule troisième phase moteur *v3* par la commande 12 ne suffit pas à entrainer le moteur électrique 10 sans retour de courant à la commande 12.

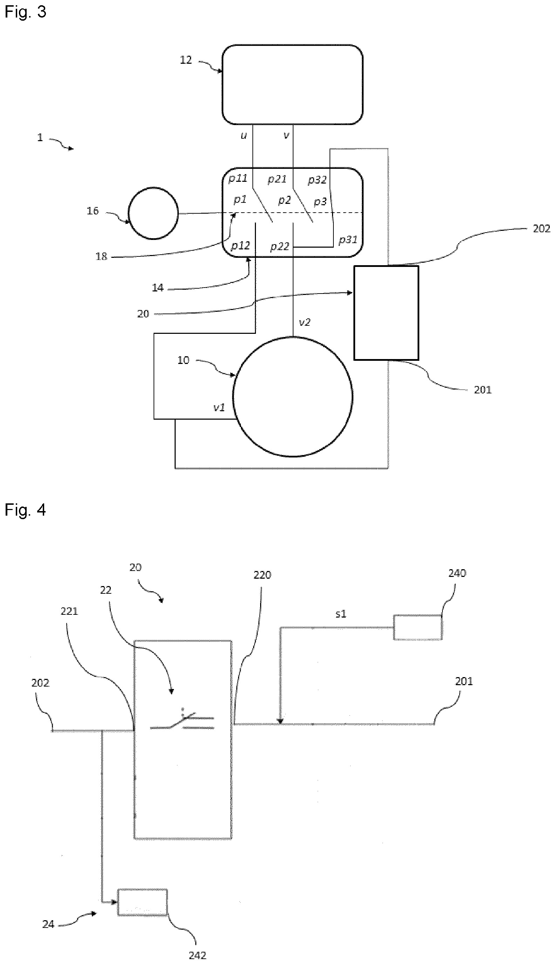

Dans une autre variante de réalisation, illustré par la figure 3, le moteur électrique 10 peut être un moteur biphasé comprenant uniquement la première phase moteur *v1* et la deuxième moteur *v2.* La commande 12 ne peut alors comprendre que deux tensions de commande (*u, v*) respectivement reliée à la première phase moteur *v1* et à la deuxième phase moteur *v2.*

Dans cette configuration, l'interrupteur de débrayage de freinage 20 permet de connecter la première phase moteur *v1* et la deuxième phase moteur *v2* entre elles. Plus précisément, la première borne 201 du premier interrupteur de débrayage de freinage 20 est reliée à la première phase moteur *v1* et la seconde borne 202 du premier interrupteur de débrayage de freinage 20 est reliée à la deuxième phase moteur *v2.* Ainsi, la première phase moteur *v1* peut être débrayée de la deuxième phase moteur *v2* et aucune des phases moteur entre la première phase moteur *v1* et la deuxième phase moteur *v2* n'est parcourue par un courant provenant de la commande 12 et aucun courant de retour ne peut se faire en direction de la commande 12.

En outre, le relais électromécanique de sécurité 14 peut alors ne comprendre que la première voie *p1* et la troisième voie *p3* basculant dans des états identiques à ce qui a été présenté précédemment.

Enfin, il peut également être envisagé que le moteur électrique 10 soit un moteur à courant continu.

Dans la suite de la description, l'interrupteur de débrayage de freinage 20 est disposé entre la deuxième phase moteur *v2* et la troisième phase moteur *v3* comme il est indiqué dans la configuration de la figure 1. Néanmoins, l'homme du métier peut adapter le détail de l'architecture de l'interrupteur de débrayage de freinage 20 de manière identique pour la configuration de la figure 2 et à la figure 3.

La figure 4 représente une vue schématique agrandie de l'interrupteur de débrayage de freinage 20 de la roue motrice entraînée en rotation par le moteur électrique 10 représenté en figure 1.

L'interrupteur de débrayage de freinage 20 est ainsi disposé entre la deuxième phase moteur *v2* du moteur électrique 10, par le biais de la troisième voie *p3,* et la troisième phase *v3* du moteur électrique 10. Plus précisément, l'interrupteur de débrayage de freinage 20 est connecté à la deuxième phase moteur *v2* du moteur électrique 10 par le biais de la seconde borne 202 qui est connectée à la troisième voie *p3* et à la troisième phase *v3* du moteur électrique 10 par le biais de la première borne 201. En effet, l'interrupteur de débrayage de freinage 20 est disposé de sorte à ouvrir la connexion entre la deuxième phase moteur *v2* et la troisième phase moteur *v3* permettant ainsi de supprimer le couple de freinage lorsque l'interrupteur de débrayage de freinage 20 est ouvert.

Il est à noter également que la première borne 201 et la deuxième borne 202 peuvent être inversées de sens. Autrement dit, la première borne 201 peut être reliée à la deuxième phase moteur *v2* alors que la deuxième borne 202 peut être reliée à la première phase moteur *v1* dans la configuration de la figure 2 ou à la troisième phase moteur *v3* dans la configuration de la figure 1.

L'interrupteur de débrayage de freinage 20 comprend une première voie de débrayage 22 connectée selon une première extrémité 220 de la première voie de débrayage 22 à la troisième phase moteur *v3* du moteur électrique 10 et à la deuxième phase *v2* du moteur électrique 10 selon une deuxième extrémité 221 de la première voie de débrayage 22. Plus précisément, la première extrémité 220 est connectée à première borne 201 et la deuxième extrémité 221 est connectée à la seconde borne 202.

La première voie de débrayage 22 est configurée pour basculer entre un état ouvert et un état fermé, à l'image d'un interrupteur. Dès lors, lorsque la première voie de débrayage 22 est dans un état fermé ou passant par rapport au courant, la deuxième phase moteur *v2* est connectée à la troisième phase moteur *v3* de sorte que le courant de freinage induisant le couple de freinage est détectable entre ces deux phases moteur. A l'inverse, lorsque la première voie de débrayage 22 est dans un état ouvert ou bloquant par rapport au courant, le courant de freinage induisant le couple de freinage n'est plus transmis entre la première extrémité 220 de la première voie de débrayage 22 et la deuxième extrémité 221 de la première voie de débrayage 22.

De plus, l'interrupteur de débrayage de freinage 20 comprend un dispositif de surveillance 24 de l'état de la première voie de débrayage. Le dispositif de surveillance 24 est configuré pour déterminer l'état de la première voie de débrayage 22 à tout instant.

Le dispositif de surveillance 24 comprend un premier émetteur d'état 240 connecté à la première extrémité 220 de la première voie de débrayage 22, configuré pour injecter un premier signal d'état *s1* entre la première extrémité 220 de la première voie de débrayage 22 et la phase moteur du moteur électrique 10 connectée à la première voie de débrayage 22 parmi la première phase moteur *v1* comme représenté en figure 2 ou la troisième phase moteur *v3* comme représenté en figure 1. Selon une configuration préférentielle, le premier émetteur d'état 240 est connecté à la première voie de débrayage 20 entre la première extrémité 220 de la première voie de débrayage 22 et la première borne 201 de l'interrupteur de débrayage de freinage 20. Comme représenté en figure 4, le premier émetteur d'état 240 est connecté à la première extrémité 220 de la première voie de débrayage 22 de sorte à injecter directement le premier signal d'état *s1* dans la première voie de débrayage 22. Le premier émetteur d'état 240 est positionné de sorte à injecter le premier signal d'état *s1* de la première borne 201 vers la deuxième borne 202 en traversant la première voie de débrayage 22. Autrement dit, le premier émetteur d'état 240 est connecté à une ligne électrique reliant la première extrémité 220 de la première voie de débrayage 22 et la première phase moteur *v1* du moteur électrique 10 dans le cas de la figure 2, ou à la troisième phase moteur *v3* du moteur électrique 10 dans le cas de la figure 1, et est configuré pour injecter le premier signal d'état *s1* en direction de la première extrémité 220, entre la première extrémité 220 de la première voie de débrayage 22 et la première phase moteur *v1* du moteur électrique 10 selon l'architecture de la figure 2, ou la troisième phase moteur *v3* du moteur électrique 10 selon l'architecture de la figure 1.

Bien que le premier signal d'état *s1* soit émis entre la première extrémité de la première voie de débrayage 22 et la première phase moteur *v1* du moteur électrique 10, comme représenté en figure 2, le premier signal d'état *s1* n'est pas apte à traverser le moteur électrique de la première phase moteur à la deuxième phase moteur et est bloqué par les bobinages du moteur électrique 10.

En effet, le premier signal d'état *s1* est un signal haute fréquence HF, de fréquence suffisamment haute pour être filtré par les bobinages du moteur électrique 10. Le moteur électrique 10 étant composé d'enroulements autour de dents constitué de matériaux magnétiques créant par nature une inductance élevée, de l'ordre de quelques millihenry, cette inductance élevée du bobinage du moteur électrique 10 permet avantageusement de bloquer le premier signal d'état *s1* entre les phases du moteur électrique 10. Le premier signal d'état *s1*, pour être filtré et bloqué par le moteur électrique 10 est donc un signal de fréquence haute par rapport à l'inductance du moteur électrique 10.

Il existe un rapport entre l'inductance L mesurable au niveau du moteur électrique 10 et la fréquence *f*₁ du premier signal d'état *s1.* Ce rapport est préférentiellement supérieure à 10⁷. Autrement dit, il la relation d'impédance au niveau du moteur électrique 10, selon la formule *JLω* où y représente le nombre complexe, L représente l'inductance du moteur électrique 10 et *ω*₁ la pulsation du premier signal d'état *s1* avec *ω*₁ = 2*πf*₁ avec *f*₁ la fréquence du premier signal d'état *s1* doit être supérieure ou égale à 100 ohms.

Le premier émetteur d'état 240 émet donc de manière continuelle un signal périodique haute fréquence, à savoir le premier signal d'état *s1*. A titre d'exemple indicatif, le premier émetteur d'état 240 peut émettre le premier signal d'état *s1* à une fréquence supérieure à 100kHz et l'inductance du moteur électrique 10 peut être égale à 1 millihenry.

Le dispositif de surveillance 24 comprend également un premier récepteur d'état 242 connecté à la deuxième extrémité 221 de la première voie de débrayage 22. Le premier récepteur d'état 242 est configuré pour détecter le premier signal d'état s1 traversant la première voie de débrayage 22 lorsque la première voie de débrayage est à l'état fermée. Il est ainsi possible de savoir l'état de bascule de la première voie de débrayage 22 à tout instant par le biais du premier récepteur d'état 242. Selon une configuration préférentielle, le premier récepteur d'état 242 est connecté entre la deuxième extrémité 221 de la première voie de débrayage 22 et la deuxième borne 202 de l'interrupteur de débrayage de freinage 20. Autrement dit, le premier récepteur d'état 242 est connecté du côté de la deuxième extrémité 221 de la première voie de débrayage 22, et est configuré pour détecter le premier signal d'état *s1* entre la deuxième extrémité 221 de la première voie de débrayage 22 et la deuxième phase moteur *v2* du moteur électrique 10. Le premier signal d'état *s1* est détecté lorsque la première voie de débrayage 22 est à l'état fermée et que le premier signal d'état *s1* traverse la première voie de débrayage, de la première extrémité 220 à la deuxième extrémité 221. Le premier signal d'état *s1* n'est pas détecté lorsque la première voie de débrayage 22 est à l'état ouvert. En effet, le premier signal d'état *s1* n'est pas apte à traverser le moteur électrique de la première phase moteur *v1* ou de la troisième phase moteur *v3* à la deuxième phase moteur *v2* et est bloqué par les bobinages du moteur électrique 10. Le premier récepteur d'état 242 est donc configuré pour déterminer l'état de la première voie de débrayage 22.

Lorsque le premier signal d'état *s1* traverse la première voie de débrayage 22 et est détecté par le premier récepteur d'état 242, le premier signal d'état n'atteint pas la deuxième phase moteur *v2* du moteur électrique 10 lorsque le moteur électrique est commandé par la commande 12. En effet, lorsque le moteur électrique 10 est commandé par la commande 12, la troisième voie *p3* est dans un état ouvert de sorte que la deuxième phase moteur *v2* n'est pas connectée à la deuxième extrémité 221 de la première voie de débrayage 22. Le premier signal d'état s1 n'est alors pas transmis à la deuxième phase moteur *v2.* Et, lorsque la troisième voie *p3* est dans l'état fermée, alors la première voie *p1* et la deuxième voie *p2* sont dans l'état ouvert de sorte que le moteur électrique 10 n'est plus alimenté par la commande 12. La troisième voie *p3* permet donc de filtrer le premier signal d'état *s1.* En effet, la troisième voie *p3* permet d'isoler le premier signal d'état *s1* du signal de la commande 12 pour éviter que le signal de la commande 12 absorbe le premier signal d'état *s1* et génère des détections incorrectes du premier récepteur d'état 242.

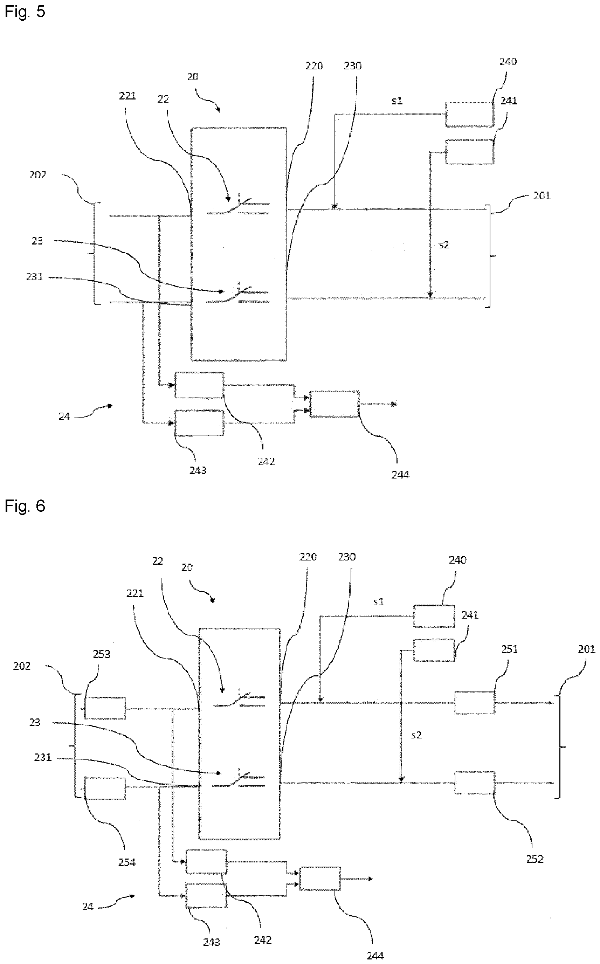

Dans un souci de de sécurité et de redondance, il peut également être envisagé que l'interrupteur de débrayage de freinage 20 comprenne comme représenté en figure 5 :
- la première voie de débrayage 22 connectée selon la première extrémité 220 de la première voie de débrayage 22 à la troisième phase moteur *v3* du moteur électrique 10 et à la deuxième phase *v2* du moteur électrique 10 par le biais de la troisième voie *p3* selon la deuxième extrémité 221 de la première voie de débrayage 22.
- une deuxième voie de débrayage 23 aussi connectée à la troisième phase moteur *v3* du moteur électrique 10 selon une première extrémité 230 de la deuxième voie de débrayage 23 et à la deuxième phase *v2* du moteur électrique 10 selon une deuxième extrémité 231 de la deuxième voie de débrayage 23.

La deuxième voie de débrayage 23 est ainsi mise en parallèle de la première voie de débrayage 22. En outre, la première extrémité 220 de la première voie de débrayage 22 et la première extrémité 230 de la deuxième voie de débrayage 23 se regroupent pour former la première borne 201 de l'interrupteur de débrayage de freinage 20 et, la deuxième extrémité 221 de la première voie de débrayage 22 ainsi que la deuxième extrémité 231 de la deuxième voie de débrayage 23 se regroupent également pour former la deuxième borne 202 de l'interrupteur de débrayage de freinage 2.

La deuxième voie de débrayage 23 est également configurée pour basculer entre l'état ouvert et l'état fermé.

Et de manière similaire, lorsque la deuxième voie de débrayage 23 est dans un état fermé ou passant par rapport au courant, la deuxième phase moteur *v2* est connectée la troisième phase moteur *v3* de sorte que le courant de freinage induisant le couple de freinage est détectable entre ces deux phases moteur. A l'inverse, lorsque la deuxième voie de débrayage 23 est dans un état ouvert ou bloquant par rapport au courant, le courant de freinage induisant le couple de freinage n'est plus transmis entre la première extrémité 230 de la deuxième voie de débrayage 23 et la deuxième extrémité 231 de la deuxième voie de débrayage 23.

La mise en parallèle de la première voie de débrayage 22 et de la deuxième voie de débrayage 23, qui répond à une problématique de redondance, présente également l'intérêt d'être adaptée à des normes de sécurité en matière de circuit électrique.

En outre, la deuxième phase moteur *v2* et la troisième phase moteur *v3* ne sont pas reliées lorsque la première voie de débrayage 22 et la deuxième voie de débrayage 23 sont simultanément dans un état ouvert.

De plus, l'état de la deuxième voie de débrayage 23 est dépendant de l'état de la première voie de débrayage 22 et, plus précisément, l'état de la deuxième voie de débrayage 23 est identique à l'état de la première voie de débrayage 22. Autrement dit, lorsque la première voie de débrayage 22 est fermée alors la deuxième voie de débrayage 23 est également fermée et, lorsque la première voie de débrayage 22 est ouverte alors la deuxième voie de débrayage 23 est également ouverte. Cependant, à l'inverse du relais électromécanique de sécurité 14, le lien de dépendance entre la première voie de débrayage 22 et la deuxième voie de débrayage 23 n'est pas assuré. Autrement dit, lorsqu'un changement d'état de l'interrupteur de débrayage de freinage 20 est requis, et que la première voie de débrayage 22 est immobilisée dans l'état initial, la deuxième voie de débrayage 23 effectue quand même la bascule vers l'état requis sans prendre en considération le lien de dépendance entre la première voie de débrayage 22 et la deuxième voie de débrayage 23 et le fait que la première voie de débrayage est non fonctionnelle. C'est notamment le cas lorsque la première voie de débrayage 22 est collée et qu'il est demandé à l'interrupteur de débrayage de freinage 20 de passer dans l'état ouvert. Dès lors, seule la deuxième voie de débrayage 23 bascule dans l'état ouvert sans respect du lien de dépendance.

Le dispositif de surveillance 24 est également configuré pour déterminer l'état de la première voie de débrayage 22 et l'état de la deuxième voie de débrayage 23 à tout instant et pour détecter lorsque la première voie de débrayage 22 est dans un état opposé à l'état de la deuxième voie de débrayage 23.

Comme représenté en figure 5, le dispositif de surveillance 24 comprend :
- le premier émetteur d'état 240 connecté à la première extrémité 220 de la première voie de débrayage 22, configuré pour injecter un premier signal d'état *s1* en direction de la première voie de débrayage 22,
- et un deuxième émetteur d'état 241 connecté à la première extrémité 230 de la deuxième voie de débrayage 23, configuré pour injecter un deuxième signal d'état *s2* en direction de la deuxième voie de débrayage 23, entre la première extrémité 230 de la deuxième voie de débrayage 23 et la phase moteur reliée à la deuxième voie de débrayage 23, à savoir la premier phase moteur *v1* ou la troisième phase moteur *v3* du moteur électrique 10. Comme énoncé précédemment, dans la configuration préférentielle, le premier émetteur d'état 240 est connecté à la première voie de débrayage 22 entre la première extrémité 220 de la première voie de débrayage 22 et la première borne 201 de l'interrupteur de débrayage de freinage 20 et le deuxième émetteur d'état 241 est connecté à la deuxième voie de débrayage 23 entre la première extrémité 230 de la deuxième voie de débrayage 23 et la première borne 201 de l'interrupteur de débrayage de freinage 20. Comme représenté en figure 5, le deuxième émetteur d'état 241 est connecté à la première extrémité 230 de la deuxième voie de débrayage 23 de sorte à injecter directement le deuxième signal d'état s2 dans la deuxième voie de débrayage 23. Le deuxième émetteur d'état 241 est positionné de sorte à injecter le deuxième signal d'état *s2* de la première borne 201 vers la deuxième borne 202 en traversant la deuxième voie de débrayage 23. Autrement dit, le deuxième émetteur d'état 241 est connecté à la ligne électrique reliant la première extrémité 230 de la deuxième voie de débrayage 23 et la phase moteur *v1* ou *v3* du moteur électrique 10 reliée à la deuxième voie de débrayage 23, et est configuré pour injecter le deuxième signal d'état *s2* en direction de la première extrémité 230, entre la première extrémité 230 de la deuxième voie de débrayage 23 et la phase moteur parmi la première phase moteur *v1* ou la troisième phase moteur *v3* du moteur électrique 10 reliée à la première borne 201.

Bien que le deuxième signal d'état *s2* soit émis entre la première extrémité 230 de la deuxième voie de débrayage 23 et la phase moteur parmi la première phase moteur *v1,* représenté en figure 2, ou la troisième phase moteur *v3,* représentée en figure 1, du moteur électrique 10 reliée à la première borne 201, le deuxième signal d'état *s2* n'est pas apte à traverser le moteur électrique 10 jusqu'à la deuxième phase moteur *v2* et est bloqué par les bobinages du moteur électrique 10.

En effet, le deuxième signal d'état *s2* est un signal haute fréquence HF, de fréquence suffisamment haute pour être filtré par les bobinages du moteur électrique 10. L'inductance élevée du bobinage du moteur électrique 10 permet avantageusement de bloquer le deuxième signal d'état *s2* entre les phases du moteur électrique 10. Le deuxième signal d'état *s2*, pour être filtré et bloqué par le moteur électrique 10 est donc un signal de fréquence haute par rapport à l'inductance du moteur électrique 10.

Comme pour le premier signal d'état *s1*, il existe un rapport entre l'inductance L mesurable au niveau du moteur électrique 10 et la fréquence *f*₂ du deuxième signal d'état *s2*. Ce rapport est préférentiellement supérieure à 10⁷. Autrement dit, il la relation d'impédance au niveau du moteur électrique 10, selon la formule *JLω* où *j* représente le nombre complexe, L représente l'inductance du moteur électrique 10 et *ω*₂ la pulsation du deuxième signal d'état s2 avec *ω*₂ = 2*πf*₂ avec *f*₂ la fréquence du deuxième signal d'état *s2* doit être supérieure ou égale à 100 ohms.

Le premier émetteur d'état 240 et le deuxième émetteur 241 émettent de manière continue un signal périodique haute fréquence, à savoir le premier signal d'état *s1* et le deuxième signal d'état *s2*. A titre d'exemple indicatif, le premier émetteur d'état 240 et le deuxième émetteur 241 émettent respectivement le premier signal d'état *s1* et le deuxième signal d'état *s2* à une fréquence supérieure à 100kHz.

Et, de manière similaire, le dispositif de surveillance 24 comprend un deuxième récepteur d'état 243 relié à la deuxième extrémité 231 de la deuxième voie de débrayage 23, en parallèle du premier récepteur d'état 242. Le deuxième récepteur d'état 243 est également configuré pour détecter le deuxième signal d'état *s2* traversant la deuxième voie de débrayage 23 lorsque la deuxième voie de débrayage est à l'état fermée. Le deuxième récepteur d'état 243 est ainsi configuré pour déterminer l'état de la deuxième voie de débrayage 23. Selon une configuration préférentielle, le deuxième récepteur d'état 243 est connecté à la deuxième voie de débrayage 23 entre la deuxième extrémité 231 de la deuxième voie de débrayage 23 et la deuxième borne 202 de l'interrupteur de débrayage de freinage 20. Autrement dit, le deuxième récepteur d'état 243 est connecté du côté de la deuxième extrémité 231 de la deuxième voie de débrayage 23, et est configuré pour détecter le deuxième signal d'état s2 entre la deuxième extrémité 231 de la deuxième voie de débrayage 23 et la deuxième phase moteur *v2* du moteur électrique 10. Le deuxième signal d'état *s2* est détecté lorsque la deuxième voie de débrayage 23 est à l'état fermé et que le deuxième signal d'état *s2* traverse la deuxième voie de débrayage 23, de la première extrémité 230 à la deuxième extrémité 231. Le deuxième signal d'état *s2* n'est pas détecté lorsque la deuxième voie de débrayage 23 est à l'état ouvert. En effet, le deuxième signal d'état *s2* n'est pas apte à traverser le moteur électrique 10 de la première phase moteur *v1* ou de la troisième phase moteur *v3* à la deuxième phase moteur *v2* et est bloqué par les bobinages du moteur électrique 10. Le deuxième récepteur d'état 243 est donc configuré pour déterminer l'état de la deuxième voie de débrayage 23.

Et, lorsque le deuxième signal d'état *s2* traverse la deuxième voie de débrayage 23 et est détecté par le deuxième récepteur d'état 243, le deuxième signal d'état *s2* n'atteint pas la deuxième phase moteur *v2* du moteur électrique 10 lorsque le moteur électrique 10 est commandé par la commande 12. En effet, lorsque le moteur électrique 10 est commandé par la commande 12, la troisième voie *p3* est dans un état ouvert de sorte que la deuxième phase moteur *v2* n'est pas connectée à la deuxième extrémité 231 de la deuxième voie de débrayage 23. Le deuxième signal d'état *s2* n'est alors pas transmis à la deuxième phase moteur *v2.* Et, lorsque la troisième voie *p3* est dans l'état fermée, alors la première voie *p1* et la deuxième voie *p2* sont dans l'état ouvert de sorte que le moteur électrique 10 n'est plus alimenté par la commande 12. La troisième voie *p3* permet donc de filtrer aussi le deuxième signal d'état *s2.* En effet, la troisième voie *p3* permet d'isoler le deuxième signal d'état *s2* du signal de la commande 12 pour éviter que le signal de la commande 12 absorbe le deuxième signal d'état *s2* et génère des détections incorrectes du deuxième récepteur d'état 243.

De plus, le dispositif de surveillance 24 comprend un dispositif de diagnostic 244 de l'état de l'interrupteur de débrayage de freinage 20 relié au premier récepteur d'état 242 et au deuxième récepteur d'état 243. Le dispositif de diagnostic 244 est configuré pour comparer l'état, à savoir ouvert ou fermé, de la première voie de débrayage 22 renvoyé par le premier récepteur d'état 242 et l'état, à savoir ouvert ou fermé, de la deuxième voie de débrayage 23 renvoyé par le deuxième récepteur d'état 243. Le dispositif de diagnostic 244 permet, grâce à cette comparaison d'état, de savoir si la première voie de débrayage 22 et la deuxième voie de débrayage 23 sont effectivement dans le même état et respectent ainsi le lien de dépendance. A l'inverse, si le dispositif de diagnostic 244 détecte que le première voie de débrayage 22 est dans un état différent de l'état de la deuxième voie de débrayage 23, alors le dispositif de diagnostic 244 détecte un défaut dans le fonctionnement de l'une des voies de débrayage parmi la première voie de débrayage 22 et la deuxième voie de débrayage 23. A titre d'exemple indicatif, si le dispositif de diagnostic 244 détecte que la première voie de débrayage 22 est dans l'état fermé et que la deuxième voie de débrayage 23 est dans l'état ouvert, alors le dispositif de diagnostic permet de mettre en évidence un défaut de fonctionnement d'une voie de débrayage.

Dès lors, le dispositif de diagnostic 244 est également configuré pour déterminer, à partir de la comparaison, si l'interrupteur de débrayage 20 est dans un état fonctionnel ou dans un état dysfonctionnel, traduisant un défaut de fonctionnement de la première voie de débrayage 22 ou de la deuxième voie de débrayage 23. Autrement dit, le dispositif de diagnostic 244 présente l'intérêt de détecter s'il y a un défaut de l'un des composants sur l'une des chaînes de transmission du premier signal d'état *s1*, c'est-à-dire entre le premier émetteur d'état 240 et le premier récepteur d'état 242 en passant par la première voie de débrayage 22 ou du deuxième signal d'état *s2*, c'est-à-dire entre le deuxième émetteur d'état 241 et le deuxième récepteur d'état 243 en passant par la deuxième voie de débrayage 23.

Le dispositif de surveillance 24 présente ainsi l'avantage de permettre de vérifier le bon fonctionnement des différentes voies de l'interrupteur de débrayage de freinage 20 en s'affranchissant de l'utilisation d'un dispositif spécifique muni de voies dédiées dont l'encombrement aurait été contraignant. En outre, un tel ensemble comprenant l'interrupteur de débrayage de freinage 20 et le dispositif de surveillance 24 présente l'avantage d'être facilement intégrable puisque reliant seulement deux phases moteur, à savoir la deuxième phase moteur *v2* et la troisième phase moteur *v3* du moteur électrique 10 et d'être un composant simple.

De manière avantageuse, l'interrupteur de débrayage de freinage 20 peut comprendre, comme représenté en figure 6, un premier filtre 251 positionné entre la phase moteur parmi la première phase moteur *v1* ou la troisième phase moteur *v3* du moteur électrique 10 reliée à la première voie de débrayage 22 et la première extrémité 220 de la première voie 22. Le premier émetteur d'état 240 injecte le premier signal d'état *s1* entre la première extrémité 220 de la première voie de débrayage 22 et le premier filtre 251. Le premier filtre 251 est configuré pour isoler les signaux du moteur électrique 10, c'est-à-dire le signal en provenance de la troisième phase moteur *v3* selon l'architecture de la figure 1, ou en provenance de la première phase moteur *v1* selon l'architecture de la figure 2, et le premier signal d'état *s1* de chaque côté du premier filtre 251. Le premier filtre 251 est configuré pour d'empêcher un signal perturbateur provenant du moteur électrique 10, de la première phase moteur *v1* ou de la troisième phase moteur *v3* de traverser le premier filtre 251 et d'atteindre la première extrémité 220 de la première voie de débrayage. Autrement dit, le premier filtre 251 empêche avantageusement le premier signal d'état *s1* d'être mélangé avec les signaux en provenance du moteur électrique 10 par le biais de la première phase moteur *v1* ou de la troisième phase moteur *v3.* La détection du premier signal d'état *s1* par le premier récepteur d'état 242 est ainsi facilitée.

Le premier filtre 251 peut également, de façon avantageuse, empêcher le premier signal d'état *s1* de traverser le premier filtre 251 et d'atteindre le moteur électrique 10. Le premier signal d'état *s1* n'est alors plus bloqué par le moteur électrique 10 mais bien par le premier filtre 251.

Autrement dit, le premier filtre 251 peut avoir deux fonctions :
- empêcher un signal perturbateur provenant d'une phase moteur parmi la première phase moteur *v1* ou la troisième phase moteur *v3,* d'être détecté par le premier récepteur d'état 242 si la première voie de débrayage 22 est fermée et que le premier émetteur d'état 240 est dysfonctionnel. Lorsque le premier émetteur d'état 240 est dysfonctionnel, le premier signal d'état *s1* n'est pas généré et le premier récepteur d'état 242 ne le détecte pas, peu importe si la première voie de débrayage 22 est à l'état fermé ou ouvert,
- et empêcher le premier signal d'état *s1* d'être absorbé par la commande 12 du moteur électrique 10.

De manière avantageuse, l'interrupteur de débrayage de freinage 20 peut comprendre un deuxième filtre 252 positionné entre la troisième phase moteur *v3* du moteur électrique 10 et la première extrémité 230 de la deuxième voie 23. Le deuxième émetteur d'état 241 injecte le deuxième signal d'état *s2* entre la première extrémité 230 de la deuxième voie de débrayage 23 et le deuxième filtre 252.

Le deuxième filtre 252 est configuré pour isoler les signaux du moteur électrique 10, c'est-à-dire le signal en provenance de la troisième phase moteur *v3* selon l'architecture de la figure 1, ou en provenance de la première phase moteur *v1* selon l'architecture de la figure 2, et le deuxième signal d'état *s2* de chaque côté du deuxième filtre 252.

Le deuxième filtre 252 est configuré pour d'empêcher un signal perturbateur provenant du moteur électrique 10, de la première phase moteur *v1* ou de la troisième phase moteur *v3,* de traverser le deuxième filtre 252 et d'atteindre la première extrémité 230 de la deuxième voie de débrayage 23.

Le deuxième filtre 252 peut également empêcher le deuxième signal d'état s2 de traverser le deuxième filtre 252 et d'atteindre le moteur électrique 10. Le moteur électrique 10 ne bloque plus le deuxième signal d'état *s2* qui est déjà filtré par le deuxième filtre 252.

Autrement dit, le deuxième filtre 252 peut avoir deux fonctions :
- empêcher un signal perturbateur provenant d'une phase moteur parmi la première phase moteur *v1* ou la troisième phase moteur *v3,* d'être détecté par le deuxième récepteur d'état 243 si la deuxième voie de débrayage 23 est fermée et que le deuxième émetteur d'état 241 est dysfonctionnel. Lorsque le deuxième émetteur d'état 241 est dysfonctionnel, le deuxième signal d'état *s2* n'est pas généré et le deuxième récepteur d'état 243 ne le détecte pas, peu importe si la deuxième voie de débrayage 23 est à l'état fermé ou ouvert
- empêcher le deuxième signal d'état s2 d'être absorbé par la commande 12 du moteur électrique 10.

Le premier filtre 251 et le deuxième filtre 252 permettent respectivement d'isoler le premier signal d'état *s1* et le deuxième signal d'état *s2* à 1MHz de la commande moteur hachée à 40kHz. Le premier filtre 251 et le deuxième filtre 252 sont ainsi capables de filtrer les harmoniques hautes fréquences de la commande moteur de ne pas polluer le premier récepteur d'état 242 et le deuxième récepteur d'état 243 avec les signaux de la commande moteur. Le premier filtre 251 et le deuxième filtre 252 permettent également respectivement que le premier signal *s1* et le deuxième signal d'état *s2* ne soient pas absorbés par la commande 12.

A titre d'exemple indicatif, le premier filtre 251 et le deuxième filtre 252 peuvent être des filtres de type en T, comprenant deux inductances et un condensateur, passe bas avec une fréquence de coupure de l'ordre de 400kHz.

En variante, le premier filtre 251 et le deuxième filtre 252 sont des filtres passe-bande.

L'interrupteur de débrayage de freinage 20 peut comprendre un troisième filtre 253 connecté à la deuxième extrémité 221 de la première voie 22, configuré pour filtrer le premier signal d'état *s1* émis par le premier émetteur d'état 240. Plus précisément, le troisième filtre 253 est connecté à la deuxième extrémité 221 de la première voie 22 et à la deuxième phase moteur *v2* du moteur électrique 10. Le premier récepteur d'état 242 détecte le premier signal d'état s1 entre la deuxième extrémité 221 de la première voie de débrayage 22 et le troisième filtre 253.

Et de manière similaire, l'interrupteur de débrayage de freinage 20 peut comprendre un quatrième filtre 254 connecté à la deuxième extrémité 231 de la deuxième voie 23, configuré pour filtrer le deuxième signal d'état s2 émis par le deuxième émetteur d'état 241. Plus précisément, le quatrième filtre 254 est connecté à la deuxième extrémité 231 de la deuxième voie 23 et à la deuxième phase moteur *v2* du moteur électrique 10. Le deuxième récepteur d'état 243 détecte le deuxième signal d'état *s2* entre la deuxième extrémité 231 de la deuxième voie de débrayage 23 et le quatrième filtre 254.

Le troisième filtre 253 permet d'éviter que le premier signal d'état *s1* se dirige au-delà de la seconde borne 202 pour revenir par la seconde borne 202 et être détecté par le deuxième récepteur d'état 243.

Le troisième filtre 253 peut également isoler le signal en provenance de la deuxième phase moteur *v2* et le premier signal d'état *s1* de chaque côté du troisième filtre 253. Le troisième filtre 253 peut également empêcher le premier signal d'état *s1* de traverser le troisième filtre 253 et d'atteindre le moteur électrique 10 par la deuxième phase moteur *v2.* Le troisième filtre 253 permet ainsi de bloquer le premier signal d'état *s1* qu'importe l'état de la troisième voie *p3* qui permet également de connecter ou non la deuxième phase moteur *v2* à l'interrupteur de débrayage de freinage 20.

Et de manière similaire, le quatrième filtre 254 permet d'éviter que le deuxième signal d'état *s2* se dirige au-delà de la seconde borne 202 pour revenir par la seconde borne 202 et être détecté par le premier récepteur d'état 242.

Le quatrième filtre 254 peut aussi isoler le signal en provenance de la deuxième phase moteur *v2* et le deuxième signal d'état *s2* de chaque côté du quatrième filtre 254. Le quatrième filtre 254 peut ainsi empêcher le deuxième signal d'état *s2* de traverser le quatrième filtre 254 et d'atteindre le moteur électrique 10 par la deuxième phase moteur *v2.*

Autrement dit, le troisième filtre 253 et le quatrième filtre 254 empêchent que le premier signal d'état *s1* et le deuxième signal d'état *s2* soient en conflit. Le troisième filtre 253 et le quatrième filtre 254 assurent ainsi un rôle de tampon ou de séparateur entre le premier signal d'état *s1* et le deuxième signal d'état *s2.*

A titre d'exemple indicatif, le troisième filtre 253 et le quatrième filtre 254 peuvent être des filtres de type en T, comprenant deux inductances et un condensateur, passe bas avec une fréquence de coupure de l'ordre de 400kHz.

En variante, le troisième filtre 253 et le quatrième filtre 254 sont des filtres passe-bande.

En effet, sans la présence du troisième filtre 253 et du quatrième filtre 254, si la deuxième voie de débrayage 23 est ouverte alors que la première voie de débrayage 22 est fermée, il est certain que le deuxième récepteur d'état 243 ne reçoit pas le deuxième signal d'état s2 mais bien seulement le premier signal d'état *s1,* qui n'est pas destiné à être détecté dans la deuxième voie de débrayage 23, et effectue pourtant une bascule dans l'état fermé alors que la deuxième voie de débrayage 23 est ouverte, ce qui traduit un dysfonctionnement du diagnostic de l'état de l'interrupteur de débrayage de freinage 20.

En outre, il peut également être envisagé d'utiliser le premier filtre 251 et le troisième filtre 253 dans la configuration de la figure 4 dans laquelle le premier interrupteur de débrayage 20 comprend seulement la première voie de débrayage 22.

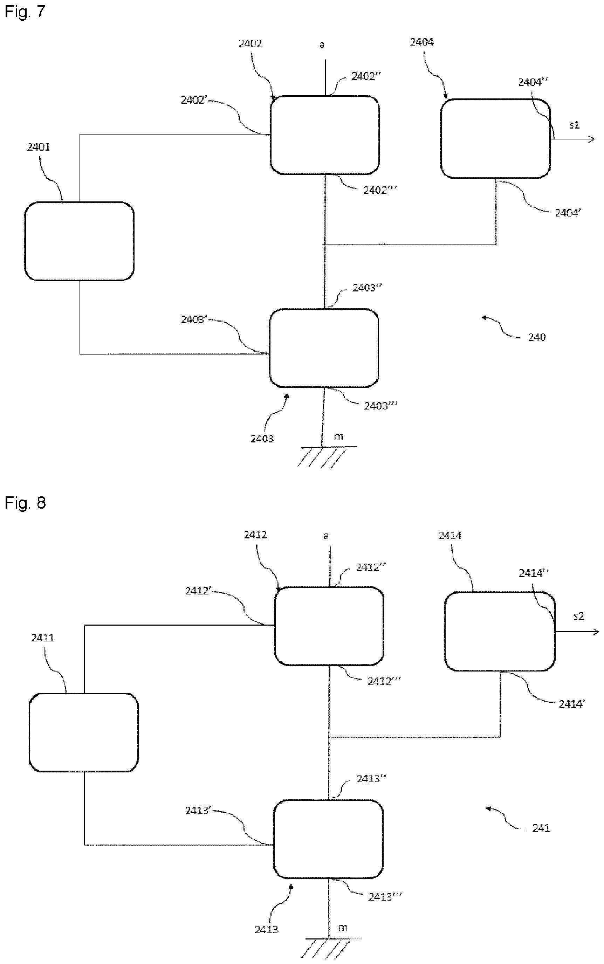

De manière avantageuse, le premier émetteur d'état 240 peut comprendre, comme représenté en figure 7 :
- une première commande 2401 configurée pour générer le premier signal d'état *s1* en direction de la première voie de débrayage 22,
- un premier transistor 2402 contrôlé par la commande 2401, connecté à la première commande 2401 selon une première borne 2402' et connecté à une alimentation a selon une deuxième borne 2402". Le premier transistor 2402 comprend également une troisième borne 2402‴.
- un deuxième transistor 2403 également connecté à la première commande 2401 par l'intermédiaire d'une première borne 2403', connecté à une masse m par l'intermédiaire d'une troisième borne 2403'" et relié à la troisième borne 2402'" du premier transistor 2402 par l'intermédiaire d'une deuxième borne 2403".

Le premier transistor 2402 et le deuxième transistor 2403 sont donc placés en parallèle de sorte à permettre de fonctionner selon un courant et une puissance plus importants. Le premier transistor 2402, le deuxième transistor 2403 et la première commande 2401 forment un hacheur qui découpe la tension l'alimentation a à une fréquence de 1MHz. Ce hachage permet de délivrer une tension importante pour être moins pollué par la commande 12 et de minimiser les pertes du circuit.

Le premier émetteur 240 peut également comprendre un premier moyen de filtrage 2404 connecté selon une première borne 2404' du premier moyen de filtrage 2404 à la troisième borne 2402'" du premier transistor 2403 et à la deuxième borne 2403" du deuxième transistor 2403 et selon une deuxième borne 2404" du premier moyen de filtrage 2404 à la première extrémité 220 de la première voie de débrayage 22.

Le premier moyen de filtrage 2404 est par exemple un filtre passe bas comprenant une inductance et un condensateur avec une fréquence de coupure d'environ 2MHz permettant de filtrer les harmoniques du hacheur et fournir un signal quasi sinusoïdal du premier signal d'état s1 afin de limiter les émissions radio et ne pas dégrader la compatibilité électromagnétique du véhicule.

En variante, le premier émetteur 240 peut être un système émettant un signal périodique sinus ou triangulaire ou carré ou en dent de scie.

En outre, le premier transistor 2402 et le deuxième transistor 2403 peuvent être des transistors bipolaires ou des transistors à effet de champ.

De manière avantageuse, le premier transistor 2402 peut comprendre une diode de roue libre reliée par l'intermédiaire d'une cathode de la première diode de roue libre à la deuxième borne 2402" du premier transistor 2402 et par l'intermédiaire d'une anode de la première diode de roue libre à la troisième borne 2402'" du premier transistor 2402.

Et, le deuxième transistor 2403 peut comprendre une deuxième diode de roue libre reliée par l'intermédiaire d'une anode de la deuxième diode de roue libre à la troisième borne 2403'" du deuxième transistor 2403 et par l'intermédiaire d'une cathode de la deuxième diode de roue libre à la deuxième borne 2403" du deuxième transistor 2403.

L'utilisation de la première diode de roue libre et de la deuxième diode de roue libre présente l'avantage de protéger le premier transistor 2402 et le deuxième transistor 2403 contre une surtension lors de l'ouverture d'une charge inductive.

Et de manière similaire, le deuxième émetteur d'état 241 comprend, comme représenté en figure 8 :
- une deuxième commande 2411 configurée pour générer le deuxième signal d'état *s2* en direction de la deuxième voie de débrayage 23,
- un troisième transistor 2412, contrôlé par la deuxième commande 2411, comprenant une première borne 2412' de troisième transistor 2412 connectée à la deuxième commande 2411, une deuxième borne 2412" de troisième transistor 2412 connectée à l'alimentation a et une troisième borne 2412'",
- un quatrième transistor 2413 comprenant une première borne 2413' de quatrième transistor 2413 connectée à la deuxième commande 2411, une troisième borne 2413‴ de quatrième transistor 2413 connectée à la masse *m* et une deuxième borne 2413" de quatrième transistor 2413 connectée à la troisième borne 2412'" du troisième transistor 2412,
- un deuxième moyen de filtrage 2414 connecté selon une première borne 2414' du deuxième moyen de filtrage 2414 à la deuxième borne 2413" du quatrième transistor 2413 et à la troisième borne 2412'" du troisième transistor 2412 et selon une deuxième borne 2414" du deuxième moyen de filtrage 2414 à la première extrémité 230 de la deuxième voie de débrayage 23.

Le troisième transistor 2412, le quatrième transistor 2413 et la deuxième commande 2411 forment un hacheur qui découpe la tension l'alimentation *a* à une fréquence de 1MHz. Ce hachage permet de délivrer une tension importante pour être moins pollué par la commande 12 et de minimiser les pertes du circuit.

Le deuxième moyen de filtrage 2414 est par exemple un filtre passe bas comprenant une inductance et un condensateur avec une fréquence de coupure d'environ 2MHz permettant de filtrer les harmoniques du hacheur et fournir un signal quasi sinusoïdal du premier signal d'état s1 afin de limiter les émissions radio et ne pas dégrader la compatibilité électromagnétique du véhicule.

En variante, le deuxième émetteur 241 peut être un système émettant un signal périodique sinus ou triangulaire ou carré ou en dent de scie.

En outre, le troisième transistor 2412 et le quatrième transistor 2413 peuvent être des transistors bipolaires ou des transistors à effet de champ.

De manière avantageuse, le troisième transistor 2412 peut comprendre une troisième diode de roue libre reliée par l'intermédiaire d'une cathode de la troisième diode de roue libre à la deuxième borne 2412" du troisième transistor 2412 et par l'intermédiaire d'une anode de la troisième diode de roue libre à la troisième borne 2412'" du troisième transistor 2412.

Et, le quatrième transistor 2413 peut comprendre une quatrième diode de roue libre reliée par l'intermédiaire d'une anode de la quatrième diode de roue libre à la troisième borne 2413‴ du quatrième transistor 2413 et par l'intermédiaire d'une cathode de la quatrième diode de roue libre à la deuxième borne 2413" du quatrième transistor 2413.

L'utilisation de la troisième diode de roue libre et de la quatrième diode de roue libre présente l'avantage de protéger le troisième transistor 2412 et le quatrième transistor 2413 contre une surtension lors de l'ouverture d'une charge inductive.

En variante la première commande 2401 et la deuxième commande 2411 peuvent être confondues.

Il peut également être envisagé, pour réduire le volume de l'ensemble, que le premier émetteur de signal 240 et le deuxième émetteur de signal 241 soient confondus.

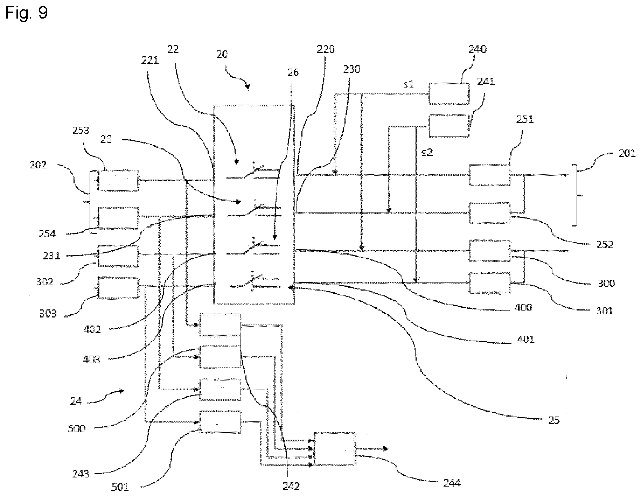

La figure 9 représente une vue schématique de l'interrupteur de débrayage de freinage 20 appliqué à deux roues motrices. Ainsi, l'interrupteur de débrayage de freinage 20 peut comprendre plus de deux voies, à savoir une voie principales et une voie secondaire de redondance, et, selon l'exemple de la figure 9, quatre voies. Plus précisément, l'interrupteur de débrayage de freinage 20 comprend deux voies, à savoir la première voie de débrayage 22 et la deuxième voie de débrayage 23, destinées à permettre de débrayer une première roue motrice par rapport à un premier moteur électrique et deux autres voies, à savoir une troisième voie de débrayage 26 et une quatrième voie de débrayage 25, destinées à permettre de débrayer une deuxième roue motrice par rapport à un deuxième moteur électrique. La troisième voie de débrayage 26 est ainsi identique à la première voie de débrayage 22, c'est-à-dire que c'est une voie principale, et la quatrième voie de débrayage 25 est identique à la deuxième voie de débrayage 23, c'est-à-dire que c'est une voie secondaire. Dès lors, le premier émetteur d'état 240 est configuré pour injecter le premier signal d'état s1 en direction de la première voie de débrayage 22 et en direction de la troisième voie de débrayage 26, et le deuxième émetteur d'état 241 est configuré pour injecter le deuxième signal d'état *s2* en direction de la deuxième voie de débrayage 23 et en direction de la quatrième voie de débrayage 25.

De manière similaire à la première voie de débrayage 22 et à la deuxième voie de débrayage 23, la troisième voie de débrayage 26 et la quatrième voie de débrayage 25 peuvent respectivement comprendre :
- un cinquième filtre 300 positionné entre une troisième phase du deuxième moteur électrique et une première extrémité 400 de la troisième voie de débrayage 26. Le cinquième filtre 300 est identique au premier filtre 251,
- un sixième filtre 301 positionné entre la troisième phase moteur du deuxième moteur électrique et une première extrémité 401 de la quatrième voie de débrayage 25, identique au deuxième filtre 252,
- un troisième récepteur d'état 500 relié à une deuxième extrémité 402 de la troisième voie de débrayage 26. Le troisième récepteur d'état 500 est configuré pour détecter le premier signal d'état *s1* traversant la troisième voie de débrayage 26 lorsque la troisième voie de débrayage 26 est à l'état fermée, de manière identique au premier récepteur d'état 242,
- un quatrième récepteur d'état 501 relié à une deuxième extrémité 403 de la quatrième voie de débrayage 25, en parallèle du troisième récepteur d'état 500. Le quatrième récepteur d'état 501 est également configuré pour détecter le deuxième signal d'état s2 traversant la quatrième voie de débrayage 25 lorsque la quatrième voie de débrayage 25 est à l'état fermée,
- le dispositif de diagnostic 244 qui est alors relié au premier récepteur d'état 242, au deuxième récepteur d'état 243, au troisième récepteur d'état 500 et au quatrième récepteur d'état 501 de sorte à comparer l'état, à savoir ouvert ou fermé, de la première voie de débrayage 22 et l'état, à savoir ouvert ou fermé, de la troisième voie de débrayage 26 et l'état, à savoir ouvert ou fermé, de la deuxième voie de débrayage 23 et l'état, à savoir ouvert ou fermé, de la quatrième voie de débrayage 25. Autrement dit, le dispositif de diagnostic 244 compare la détection du premier signal d'état *s1* dans les voies dans lesquelles le premier signal d'état *s1* est transmis et compare la détection du deuxième signal d'état *s2* dans les voies dans lesquelles le deuxième signal d'état *s2* est transmis. En outre, le dispositif de diagnostic 244 fonctionne également de sorte à comparer l'état des autre voies de débrayages, à savoir la première voie de débrayage 22, la deuxième voie de débrayage 23, la troisième voie de débrayage 26 et la quatrième voie de débrayage 25,
- Un septième filtre 302 connecté entre la deuxième extrémité 402 de la troisième voie de débrayage 26 et une deuxième phase moteur du deuxième moteur électrique, configuré pour filtrer le premier signal d'état *s1* émis par le premier émetteur d'état 240 de manière similaire au troisième filtre 253.
- Un huitième filtre 303 connecté entre à la deuxième extrémité 403 de la quatrième voie 25 et une deuxième phase moteur du deuxième moteur électrique, configuré pour filtrer le deuxième signal d'état *s2* émis par le deuxième émetteur d'état 241, de manière similaire au quatrième filtre 254.

Ainsi, l'invention a trait à un interrupteur de débrayage de freinage 20 permettant de découpler un dispositif de freinage 1 en situation de freinage du moteur électrique 10 et de la roue motrice de sorte à permettre de laisser libre la roue motrice. L'interrupteur de débrayage de freinage 20 permet de déconnecter entre elles deux phases moteur d'un moteur électrique 10 comprenant au moins deux phases, ces deux phases étant connectées entre elles. Ces deux phases moteur connectées entre elles peuvent être les deux phases moteur du moteur électrique biphasé, c'est-à-dire la première phase moteur *v1* et la deuxième phase moteur *v2,* comme représenté en figure 3. Dans un moteur triphasé, ces deux phase moteur connectées entre elles peuvent être la deuxième phase moteur *v2* et la troisième phase moteur *v3* comme représenté en figure 1 ou la première phase moteur *v1* et la troisième phase moteur *v3* comme représenté en figure 2. L'interrupteur de débrayage présente l'avantage d'être compact, facilement intégrable dans le dispositif de freinage 1 du véhicule et présentant un faible coût financier. Néanmoins, l'invention a également trait à un dispositif de freinage 1 comme représenté en figure 1 comprenant l'interrupteur de débrayage 20 ainsi que le dispositif de surveillance 24 de l'interrupteur de débrayage. L'invention a également trait à un véhicule configuré pour se mouvoir dans une zone de déplacement et comprenant le moteur électrique 10, la commande 12, le relais électromécanique de sécurité 14 ainsi que l'interrupteur de débrayage de freinage 20 apte à se déplacer de manière autonome ou de manière télécommandée comme par exemple un robot autonome ou piloté tel qu'un robot autonome de livraison.

## Revendications

1. Interrupteur de débrayage (20) de freinage magnétique d'une roue motrice entraînée en rotation par un moteur électrique (10) comprenant au moins deux phases moteur, l'interrupteur de débrayage (20) comprenant une première voie de débrayage (22) destinée à être connectée selon une première extrémité (220) de la première voie de débrayage (22) à une phase moteur *(v1, v3)* du moteur électrique (10) et à une deuxième phase moteur (*v2*) du moteur électrique (10) selon une deuxième extrémité (221) de la première voie de débrayage (22), la première voie de débrayage (22) étant configurée pour basculer entre un état ouvert et un état fermé, l'interrupteur de débrayage (20) comprenant un dispositif de surveillance (24) de l'état de la première voie de débrayage (22), le dispositif de surveillance (24) comprenant :
- un premier émetteur d'état (240) connecté à la première extrémité (220) de la première voie de débrayage (22), configuré pour injecter un premier signal d'état (*s1*) entre la première extrémité (220) de la première voie de débrayage (22) et la phase moteur (*v1, v3*) du moteur électrique (10),
- un premier récepteur d'état (242) connecté la deuxième extrémité (221) de la première voie de débrayage (22), le premier récepteur d'état (242) étant configuré pour détecter le premier signal d'état (s1) traversant la première voie de débrayage (22) lorsque la première voie de débrayage (22) est à l'état fermée, le premier récepteur d'état (242) étant configuré pour déterminer l'état de la première voie de débrayage (22).

2. Interrupteur de débrayage (20) de freinage magnétique selon la revendication 1, comprenant un premier filtre (251) positionné entre la phase moteur (*v1, v3*) du moteur électrique (10) et la première extrémité (220) de la première voie de débrayage (22), le premier filtre (251) étant configuré pour recevoir et filtrer un signal de la phase moteur *(v1, v3)* du moteur électrique (10).

3. Interrupteur de débrayage (20) de freinage magnétique selon la revendication 1 ou la revendication 2, dans lequel le premier émetteur d'état (240) comprend :
- une première commande (2401) configurée pour générer le premier signal d'état (*s1*),
- un premier transistor (2402) connecté à la première commande (2401) selon une première borne (2402'), connecté à une alimentation (*a)* selon une deuxième borne (2402") et comprenant une troisième borne (2402‴),
- un deuxième transistor (2403) connecté à la première commande (2401) par l'intermédiaire d'une première borne (2403'), connecté à une masse (m) par l'intermédiaire d'une troisième borne (2403‴) et connecté à la troisième borne (2402‴) du premier transistor (2402) par l'intermédiaire d'une deuxième borne (2403"),
- un premier moyen de filtrage (2404) connecté selon une première borne (2404') du premier moyen de filtrage (2404) à la troisième borne (2402‴) du premier transistor (2403) et à la deuxième borne (2403") du deuxième transistor (2403) et selon une deuxième borne (2404") du premier moyen de filtrage (2404) à la première extrémité (220) de la première voie de débrayage (22).

4. Interrupteur de débrayage (20) de freinage magnétique selon l'une des revendications 1 à 3, dans lequel le premier signal d'état (*s1*) est un signal périodique de fréquence supérieur ou égale à 100kHz.

5. Interrupteur de débrayage (20) de freinage magnétique selon la revendication 1 à 4, dans lequel le premier filtre (251) est un filtre passe-bas.

6. Interrupteur de débrayage (20) de freinage magnétique selon la revendication 5, dans lequel le premier filtre (251) est un filtre de type en T, comprenant deux inductances et un condensateur.

7. Interrupteur de débrayage (20) de freinage magnétique selon l'une des revendications 1 à 6, comprenant un troisième filtre (253) connecté à la deuxième extrémité (221) de la première voie de débrayage (22), configuré pour filtrer le premier signal d'état (*s1*) émis par le premier émetteur d'état (240).

8. Interrupteur de débrayage (20) de freinage magnétique selon l'une des revendications 1 à 7, comprenant une deuxième voie de débrayage (23) connectée à la phase moteur du moteur électrique (10) selon une première extrémité (230) de la deuxième voie de débrayage (23) et à la deuxième phase moteur (*v2*) du moteur électrique (10) selon une deuxième extrémité (231) de la deuxième voie de débrayage (23), la deuxième voie de débrayage (23) étant configurée pour basculer entre un état ouvert et un état fermé, la deuxième voie de débrayage (23) étant configurée pour être dans le même état que la première voie de débrayage (22), le dispositif de surveillance (24) étant configuré pour surveiller l'état de la deuxième voie de débrayage (23), le dispositif de surveillance (24) comprenant :
- un deuxième émetteur d'état (241) connecté à la première extrémité (230) de la deuxième voie de débrayage (23), configuré pour injecter un deuxième signal d'état (*s2*) entre la première extrémité (230) de la deuxième voie de débrayage (23) et la phase moteur *(v1, v3)* du moteur électrique (10),
- un deuxième récepteur d'état (243) connecté à la deuxième extrémité (231) de la deuxième voie de débrayage (23), le deuxième récepteur d'état (243) étant configuré pour détecter le deuxième signal d'état (*s2*) traversant la deuxième voie de débrayage (23) lorsque la deuxième voie de débrayage (23) est à l'état fermée, le deuxième récepteur d'état (243) étant configuré pour déterminer l'état de la deuxième voie de débrayage (23),
- un dispositif de diagnostic (244) de l'état de l'interrupteur de débrayage (20), le dispositif de diagnostic (244) étant relié au premier récepteur d'état (242) et au deuxième récepteur d'état (243), le dispositif de diagnostic (244) étant configuré pour comparer l'état de la première voie de débrayage (22) et l'état de la deuxième voie de débrayage (23), le dispositif de diagnostic (244) étant configuré pour déterminer, à partir de la comparaison, si l'interrupteur de débrayage (20) est dans un état fonctionnel ou dans un état dysfonctionnel.

9. Interrupteur de débrayage (20) de freinage magnétique selon la revendication 8, dans lequel le deuxième émetteur d'état (241) comprend :
- une deuxième commande (2411) configurée pour générer le deuxième signal d'état (*s2*),
- un troisième transistor (2412) comprenant une première borne (2412') de troisième transistor (2412) connectée à la deuxième commande (2411), comprenant une deuxième borne (2412") de troisième transistor (2412) connectée une l'alimentation (*a)* et une troisième borne (2412‴),
- un quatrième transistor (2413) comprenant une première borne (2413') de quatrième transistor (2413) connectée à la deuxième commande (2411), comprenant une troisième borne (2413'") de quatrième transistor (2413) connectée à une masse (*m)* et une deuxième borne (2413") de quatrième transistor (2413) connectée à la troisième borne (2412‴) du troisième transistor (2412),
- un deuxième moyen de filtrage (2414) connecté selon une première borne (2414') du deuxième moyen de filtrage (2414) à la deuxième borne (2413") du quatrième transistor (2413) et à la troisième borne (2412‴) du troisième transistor (2412) et selon une deuxième borne (2414") du deuxième moyen de filtrage (2414) à la première extrémité (230) de la deuxième voie de débrayage (23).

10. Interrupteur de débrayage (20) de freinage magnétique selon la revendication 8 ou la revendication 9, dans lequel le deuxième signal d'état (*s2)* est un signal périodique de fréquence supérieur ou égale à 100kHz.

11. Interrupteur de débrayage (20) de freinage magnétique (20) selon l'une des revendications 7 à 10, comprenant un deuxième filtre (252) positionné entre la phase moteur (*v3*) du moteur électrique (10) et la première extrémité (230) de la deuxième voie de débrayage (23), configuré pour recevoir et filtrer un signal de la phase moteur (*v3*) du moteur électrique (10).

12. Interrupteur de débrayage (20) de freinage magnétique selon la revendication 11, dans lequel le deuxième filtre (252) est un filtre passe-bas.

13. Interrupteur de débrayage (20) de freinage magnétique selon la revendication 12, dans lequel le deuxième filtre (252) est un filtre de type en T, comprenant deux inductances et un condensateur.

14. Interrupteur de débrayage (20) de freinage magnétique selon l'une des revendications 7 à 13, comprenant un quatrième filtre (254) connecté à la deuxième extrémité (231) de la deuxième voie de débrayage (23), configuré pour filtrer le deuxième signal d'état (*s2*) émis par le deuxième émetteur d'état (241).

15. Interrupteur de débrayage (20) de freinage magnétique selon l'une des revendications 1 à 14, dans lequel le moteur électrique (10) comprend trois phases moteur *(v1, v2, v3),* la phase moteur étant une phase moteur parmi la première phase moteur (*v1*) ou la troisième phase moteur (*v3*).

16. Véhicule configuré pour se mouvoir dans une zone de déplacement, le véhicule comprenant l'interrupteur de débrayage (20) de freinage magnétique selon l'une quelconque des revendications précédentes.
